# EUROPÄISCHE PATENTANMELDUNG

(11) **EP 0 766 373 A1**
(43) Veröffentlichungstag der Anmeldung: **02.04.1997**
(21) Anmeldenummer: 96202672.0
(22) Anmeldetag: 24.09.1996
(51) Int. Cl.: H02M 7/10, G01R 15/04, H05G 1/26

(54) **Hochspannungsgenerator**

(30) Priorität: 30.09.1995 DE 19536653
(71) Anmelder: Philips Patentverwaltung GmbH, 22335 Hamburg (DE); PHILIPS ELECTRONICS N.V., 5621 BA Eindhoven (NL)
(72) Erfinder: Wimmer, Martin, c/o Philips Patentverwaltung GmbH, 22335 Hamburg (DE)
(74) Vertreter: Hartmann, Heinrich, Dipl.-Ing.

(57) **Zusammenfassung**

Die Erfindung betrifft einen Hochspannungsgenerator mit einer Gleichrichterschaltung (9) und einer Meßwiderstandsanordnung (8) zur Bildung einer der Gleichspannung (U_{DC}) proportionalen Meßspannung (U_{M}), wobei die Meßwiderstandsanordnung (9) pro Gleichrichterstufe (31, 32, 33) mindestens einen zugehörigen Meßwiderstand (R₁, R₂, R₃) aufweist. Um einen kostengünstigen und vor allem platzsparenden Aufbau zu erreichen, bei dem auch eine ausreichende Abschirmung der Meßwiderstände (R₁, R₂, R₃) von den Wechselspannung führenden Teilen (C₄...C₉, 1, 2, 3) der Schaltung und vom Erdpotential gegeben ist, sind die Meßwiderstände (R₁, R₂, R₃) in die zugehörigen Gleichrichterstufen (31, 32, 33) integriert und von einem Schirm (11, 12, 13) umgeben, der auf dem Gleichspannungspotential der zugehörigen Gleichrichterstufe (31, 32, 33) liegt.

## Beschreibung

Die Erfindung betrifft einen Hochspannungsgenerator zur Erzeugung einer Gleichspannung aus einer Wechselspannung mit einer mehrere Gleichrichterstufen aufweisenden Gleichrichterschaltung und einer Meßwiderstandsanordnung zur Bildung einer der Gleichspannung proportionalen Meßspannung, wobei die Meßwiderstandsanordnung pro Gleichrichterstufe mindestens einen zugehörigen Meßwiderstand aufweist.

Ein solcher Hochspannungsgenerator ist aus der JP-A 2-156 163 bekannt. Die Eingangswechselspannung wird dort von einem Transformator mit mehreren Sekundärwicklungen hochtransformiert. Jeder Sekundärwicklung ist eine Gleichrichterstufe zugeordnet, die aus der an der Sekundärwicklung anliegenden Wechselspannung eine Gleichspannung erzeugt. Die Gleichrichterstufen sind in Reihe geschaltet, so daß sich die gesamte Ausgangsgleichspannung des Hochspannungsgenerators durch Addition der einzelnen Gleichspannungen ergibt. Die Meßwiderstandsanordnung umfaßt dort mehrere in Serie geschaltete Meßwiderstände sowie einen Fußpunktwiderstand über dem die Meßspannung abgegriffen wird.

Ein Hochspannungsgenerator für eine Röntgenröhre ist aus der EP-A 118 147 bekannt. Die Meßwiderstandsanordnung umfaßt dort ebenfalls mehrere Meßwiderstände sowie einen Fußpunkt-Widerstand. Diese Meßspannung von einigen Volt muß in einem Frequenzbereich von 0 bis einigen 100 kHz möglichst exakt der Hochspannung proportional sein. Zur elektrostatischen Abschirmung gegenüber der Umgebung sind deshalb die Meßwiderstände von einem an die Hochspannung angeschlossenen Dämpfungswiderstand umschlossen.

Um den Einfluß relativ großer parasitärer Kapazitäten und Zuleitungsinduktivitäten der Meßwiderstände zu vermeiden, die die Meßspannung verfälschen würden, sind den in Serie geschalteten Meßwiderständen bei den bekannten Hochspannungsgeneratoren Kondensatoren parallel geschaltet. Dadurch soll eine große Übertragungsbandbreite erreicht werden. Derartige Kompensationskondensatoren sind jedoch teuer und haben einen großen Platzbedarf.

Bei modernen Hochspannungsgeneratoren ist es durch Verwendung einer hohen und konstanten Schaltfrequenz (im Bereich von 20 kHz) bei Regelvorgängen möglich, die Ausgangsspannungswelligkeit gering zu halten. Damit kann auf die genaue Messung des Spitzenwerts der Ausgangsspannung bei hohen Frequenzen von einigen 100 kHz verzichtet werden, weil dieser nur geringfügig höher als der Mittelwert der Ausgangsspannung ist und beispielsweise bei Röntgenanlagen im Bereich zulässiger Abweichungen liegt. Die Grenzfrequenz des Generators, für die das Frequenzverhalten der Meßwiderstandsanordnung ausgelegt werden muß, hängt von der Grenzfrequenz des geschlossenen Regelkreises ab und liegt bei diesen Hochspannungsgeneratoren im Bereich von einigen kHz (bis etwa 10 kHz).

Der vorliegenden Erfindung liegt die Aufgabe zugunde, einen Hochspannungsgenerator der eingangs genannten Art kostengünstig und platzsparend auszubilden.

Diese Aufgabe wird erfindungsgemäß dadurch gelöst, daß die Meßwiderstände räumlich in die zugehörigen Gleichrichterstufen ingetriert sind, daß die Meßwiderstände von einem leitfähigen, auf Gleichspannungspotential liegenden Schirm umgeben sind zur Abschirmung der Meßwiderstandsanordnung gegen Erdpotential und gegen Wechselspannung führende Teile des Hochspannungsgenerators und daß der Schirm auf dem Gleichspannungspotential der zugehörigen Gleichrichterstufe liegt.

Während bei den bekannten Hochspannungsgeneratoren die Meßwiderstandsanordnung und die Gleichrichterschaltung räumlich voneinander getrennt angeordnet sind, ist hier eine Anordnung möglich, bei der Meßwiderstandsanordnung und Gleichrichterschaltung zusammen in einem Aufbau kombiniert sind. Jeder Meßwiderstand ist in der zugehörigen Gleichrichterstufe angeordnet, beispielsweise auf derselben Leiterplatte oder in geringem Abstand neben oder oberhalb davon. Jeder Meßwiderstand ist von einem Schirm umgeben, der auf dem Gleichspannungspotential der Gleichrichterstufe, in deren Aufbau der Meßwiderstand integriert ist, liegt. Es können so keine parasitären Streukapazitäten mehr zwischen den Meßwiderständen und Wechselspannung führenden Teilen und zwischen den Meßwiderständen und auf Erdpotential liegenden Teilen mehr auftreten, über die bei schnellen Änderungen der Hochspannung Ströme fließen können und dadurch zu einer Verfälschung der Meßspannung führen. Aufgrund der Abschirmung der Meßwiderstände ergeben sich bei dem erfindungsgemäßen Hochspannungsgenerator dagegen parasitäre Streukapazitäten zwischen den Schirmen und Wechselspannung führenden Teilen bzw. zwischen den Schirmen und dem Erdpotential, weshalb bei schnellen Änderungen der Hochspannung Ströme nicht mehr über die Meßwiderstände fließen und die Meßspannung verfälschen. Zu den einzelnen Meßwiderständen parallel geschaltete Kompensationskondensatoren wie bei den bekannten Hochspannungsgeneratoren können hier somit entfallen.

Bereits das Weglassen der Kompensationskondensatoren führt zu einer erheblichen Platz- und Kostenersparnis. Eine weitere Platzersparnis wird durch den kompakten Aufbau, bei dem die Meßwiderstände in den Aufbau der zugehörigen Gleichrichterstufe integriert sind, erreicht. Da jeder jeweils mindestens einen Meßwiderstand umgebende Schirm mit dem Gleichspannungspotential der zugehörigen Gleichrichterstufe verbunden ist, wird eine sehr gute kapazitive Entkopplung von den mit Wechselspannung beaufschlagten Punkten in der Umgebung und vom Erdpotential und letztlich im gewünschten Frequenzbereic bis etwa 10 kHz eine ausreichende Meßgenauigkeit erreicht.

Eine Ausgestaltung der Erfindung sieht vor, daß die Meßwiderstände in einem Abstand von der zugehörigen Gleichrichterstufe angeordnet und von einem als Schirm wirkenden dünnen Metallblech umgeben sind. Der Abstand des Meßwiderstands braucht dabei nur einen bis wenige Zentimeter zu betragen. Bereits ein einfaches und billiges Metallblech erfüllt den Zweck der Abschirmung.

In einer bevorzugten Weiterbildung der Erfindung ist vorgesehen, daß die Gleichrichterschaltung eine aus Kondensatoren und Dioden aufgebaute Hochspannungskaskadenschaltung ist. Eine Hochspannungskaskadenschaltung zur Spannungsvervielfachung bei einer Röntgenvorrichtung ist beispielsweise aus der EP-B 198 741 bekannt. Bei dem erfindungsgemäßen Hochspannungsgenerator wird durch die Integration der Meßwiderstände in die Gleichrichterstufen der Hochspannungskaskadenschaltung eine deutliche Platzeinsparung erreicht gegenüber herkömmlichen Hochspannungsgeneratoren, bei denen die Meßwiderstands-anordnung mit den Meßwiderständen und die Hochspannungskaskadenschaltung räumlich getrennt, beispielsweise auf zwei großen Leiterplatten angeordnet sind.

Erfindungsgemäß sieht eine Weiterbildung vor, daß der Schirm ein U-förmiges Blech ist, das den Meßwiderstand zu den Seiten hin von den Wechselspannung führenden Kondensatoren der Hochspannungskaskadenschaltung abschirmt. Das abschirmende Blech, das auf dem Potential der zugehörigen Gleichrichterstufe der Hochspannungskaskadenschaltung liegt ermöglicht es, den Meßwiderstand in geringem Abstand von den Kondensatoren anzuordnen, beispielsweise direkt auf der Leitetplatte oder in geringem Abstand oberhalb der Leiterplatte. Das U-förmige Blech ist dabei so anzuordnen, daß dessen Schenkelflächen zwischen den Kondensatoren und dem Meßwiderstand liegen.

Bei einer besonders platzsparenden Ausführung der Erfindung ist vorgesehen, daß die Gleichrichterschaltung und die Meßwiderstandsanordnung auf einer einzigen Leiterplatte angeordnet sind. Der erfindungsgemäße Hochspannungsgenerator hat dann verglichen mit Hochspannungsgeneratoren der bekannten Art eine geringe Bauhöhe und ein geringes Bauvolumen.

Bei dem erfindungsgemäßen Hochspannungsgenerator ergeben sich aufgrund der Abschirmung der Meßwiderstände keine parasitären Kapazitäten mehr zwischen den Meßwiderständen und dem Erdpotential oder zwischen den Meßwiderständen und Wechselspannung führenden Teilen, über die Wechselströme fließen und damit das Meßsignal verfälschen könnten. Aufgrund der vorgenannten Eigenschaften eignet sich der erfindungsgemäße Hochspannungsgenerator zur Ansteuerung einer Röhre, insbesondere einer Bildröhre, oder einer Röntgenröhre in einer Röntgenanlage.

Die Erfindung wird nachfolgend anhand der Zeichnung näher erläutert. Es zeigen:
- Fig. 1: ein Schaltbild eines erfindungsgemäßen Hochspannungsgenerators für eine Röntgenröhre,
- Fig. 2: ein weiteres Schaltbild eines erfindungsgemäßen Hochspannungsgenerators mit einer Hochspannungskaskadenschaltung und
- Fig. 3: eine Teildarstellung des mechanischen Aufbaus der Schaltung gemäß Fig. 2.

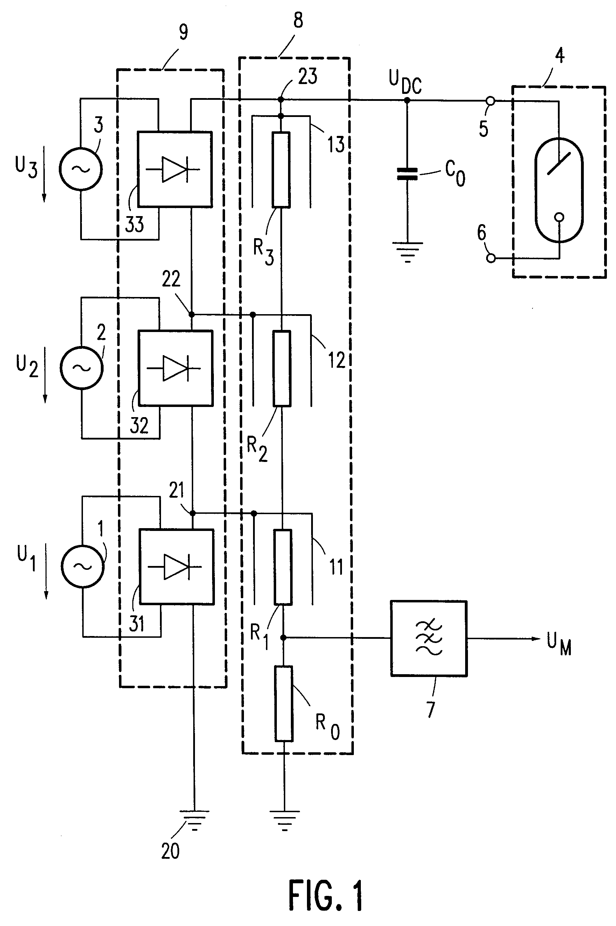

In Figur 1 ist das Schaltbild eines erfindungsgemäßen Hochspannungsgenerators für eine Röntgenröhre mit drei Wechselspannungsquellen 1,2.3 dargestellt. Deren Ausgangsspannungen U₁, U₂, U₃ werden auf eine Gleichrichterschaltung 9 gegeben, wobei für jede der Wechselspannungsquellen 1,2,3 eine Gleichrichterstufe 31,32,33 vorgesehen ist, die die entsprechende Wechselspannung U₁, U₂, U₃ in eine Gleichspannung transformiert. Die Gleichrichterstufen 31,32,33 sind in Reihe geschaltet, so daß sich am Ausgang des Hochspannungsgenerators eine Gleichspannung U_{DC} abgreifen läßt, die der Summe der Ausgangs-Gleichspannungen der Gleichrichterstufen 31,32,33 entspricht. Die Hochspannung U_{DC} dient zur Speisung einer Röntgenröhre 4, wobei der Ausgang des gezeigten Hochspannungsgenerators hier mit dem Anodenanschluß 5 der Röntgenröhre 4 verbunden ist. Der Kathodenanschluß 6 ist mit einem weiteren nicht gezeigten Hochspannungsgenerator verbunden, der eine negative Gleichspannung erzeugt. Am Ausgang 23 des Hochspannungsgenerators ist weiterhin ein Glättungskondensator Cₒ gegen Masse angeschlossen, durch den die Ausgangsspannung U_{DC} geglättet wird.

Parallel zum Glättungskondensator Cₒ ist am Ausgang 23 des Hochspannungsgenerators eine Meßwiderstandsanordnung 8 angeschlossen. Die Meßwiderstandsanordnung 8 weist pro Gleichrichterstufe 31,32,33 einen Meßwiderstand R₁, R₂, R₃ sowie einen Fußpunktwiderstand R₀ auf, die in Reihe gegen Masse 20 geschaltet sind. Die Meßwiderstände R₁, R₂, R₃ weisen jeweils den gleichen Widerstandswert auf, der etwa 1000 bis 10000-fach größer ist als der Widerstandswert des Fußpunktwiderstandes R₀. Über ein Tiefpaßfilter 7 wird zwischen dem untersten Meßwiderstand R₁ und dem Fußpunktwiderstand R₀ die gewünschte Meßspannung U_{M} abgegriffen, die aufgrund der Dimensionierung der Widerstände einem geringen Anteil der Hochspannung U_{DC} entspricht und zur Hochspannung U_{DC} proportional ist.

Die Meßwiderstände R₁, R₂, R₃ sind jeweils von einem leitfähigen Schirm 11,12,13 umgeben, wobei jeder Schirm auf dem Ausgangspotential der zugehörigen Gleichrichterstufe 31,32,33 liegt. Beispielsweise ist dazu der den Meßwiderstand R₁ umgebende Schirm 11 am Punkt 21 mit dem Ausgangspotential der Gleichrichterstufe 31 verbunden. Ebenso ist der Schirm 12 am Punkt 22 sowie der Schirm 13 am Punkt 23 mit dem Ausgang der Gleichrichterstufe 32 bzw. 33 verbunden. Durch diese Abschirmung wird erreicht, daß die Meßwiderstände R₁, R₂,R₃ kapazitiv einerseits von den Wechselspannung führenden Teilen des Hochspannungsgenerators, nämlich den Wechselspannungsquellen 1,2,3 sowie den Eingängen der Gleichrichterstufen 31,32,33 entkoppelt sind. Andererseits sind die Meßwiderstände R₁, R₂, R₃ auch kapazitiv vom Erdpotential 20 entkoppelt. Die Bandbreite der Meßwiderstandsanordnung reicht bis zur Grenzfrequenz des Hochspannungsgenerators, die von der Schaltfrequenz bei Regelvorgängen des Generators abhängt und wenige kHz beträgt. Die gezeigte Abschirmung reicht zwar nicht aus, auch hochfrequente Ausgangsspannungsschwankungen (> 20 kHz) im Meßsignal U_{M} exakt darzustellen, dies ist jedoch bei der Verwendung moderner Hochspannungsgeneratoren, bei denen der Spitzenwert der Ausgangsspannungsschwankung 2% des Durchschnittswertes der Ausgangsspannung nicht übersteigt, nicht erforderlich. Deshalb und wegen der ausreichenden Abschirmung der Meßwiderstände ist die Verwendung von parallel zu den Meßwiderständen R₁, R₂, R₃ geschalteten Kompensationskondensatoren, wie in der EP-A-118147 beschrieben ist, nicht erforderlich. Dadurch wird eine deutliche Kostenersparnis aufgrund der geringen Anzahl von Bauteilen für die Meßwiderstandsanordnung sowie eine große Platzersparnis aufgrund des kompakten Aufbaus erreicht.

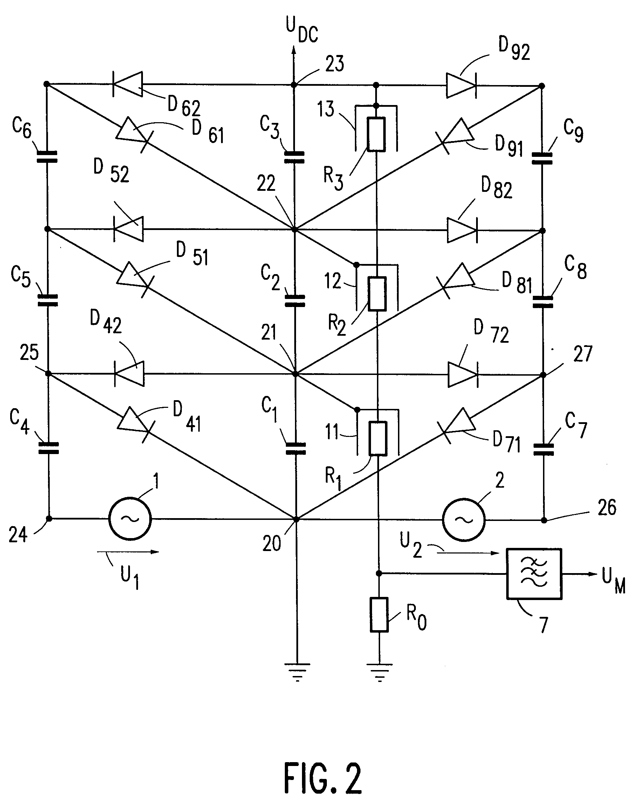

In Fig. 2 ist das Schaltbild eines erfindungsgemäßen Hochspannungsgenerators mit einer Hochspannungskaskadenschaltung dargestellt. Die Hochspannungskaskadenschaltung, die die Wechselspannungen U₁ und U₂ der Wechselspannungsquellen 1 bzw. 2 in eine Ausgangsgleichspannung U_{DC} mit maximal dem sechsfachen der Spitzenspannung der Wechselspannungsquellen 1,2 transformiert, besteht dabei aus drei in Serie geschalteten Zweiweg-Verdopplerstufen. Jede dieser Zweiweg-Verdopplerstufen besteht hierbei aus zwei Schubkondensatoren C₄...C₉, einem Glättungskondensator C₁...C₃ sowie 4 Dioden D₄₁, D₄₂, D₅₁....D₉₂. Die erste Zweiweg-Verdopplerstufe beispielsweise weist den Schubkondensator C₄ auf, dessen erster Anschlußpunkt 24 an der Wechselspannungsquelle 1 angeschlossen und dessen zweiter Anschlußpunkt 25 an den beiden Dioden D₄₁ und D₄₂ angeschlossen ist. Die zweiten Anschlußpunkte der beiden Dioden D₄₁ und D₄₂ sind mit jeweils einem Anschlußpunkt 20 bzw. 21 des Glättungskondensators C₁ verbunden, wobei der Anschlußpunkt 20 an Masse liegt. Spiegelbildlich zum Glättungskondensator C₁ ist der zweite Teil der ersten Zweiweg-Verdopplerstufe mit dem Schubkondensator C₇ und den beiden Dioden D₇₁ und D₇₂ angeordnet. An den Anschlußpunkten 21, 25 und 27 ist die zweite Zweiweg-Verdopplerstufe und daran anschließend die dritte Zweiweg-Verdopplerstufe, die jeweils in gleicher Weise aufgebaut sind, angeschlossen. Am oberen Anschlußpunkt 23 des Glättungskondensators C₃ der dritten Zweiweg-Verdopplerstufe liegt die Ausgangs-Gleichspannung U_{DC} an. Die Funktionsweise und der genaue Aufbau einer derartig aufgebauten Hochspannungskaskadenschaltung ist beispielsweise aus der EP-B 198 741 bekannt und soll deshalb hier nicht näher erläutert werden.

Am Ausgang 23 der Hochspannungskaskadenschaltung ist die Serienschaltung der Meßwiderstände R₁, R₂, R₃ angeschlossen, die gegen Masse mit dem Fußpunktwiderstand R₀ abgeschlossen ist, über dem die Meßspannung U_{M} über ein Tiefpaßfilter 7 abgegriffen wird. Die Meßwiderstände R₁, R₂, R₃ sind jeweils mit einem leitfähigen Schirm 11, 12, 13 umgeben, wobei jeder Schirm 11, 12, 13 auf der Ausgangsgleichspannung der zugehörigen Verdopplerstufe liegt. Dazu ist der Schirm 11 mit dem Punkt 21, der Schirm 12 mit dem Punkt 22 und der Schirm 13 mit dem Punkt 23 verbunden. Dies bewirkt auch hier die bereits im Zusammenhang mit Fig. 1 beschriebene Entkopplung der Meßwiderstandsanordnung von dem Erdpotential und den mit Wechselspannung beaufschlagten Punkten, insbesondere den Schubkondensatoren C₄...C₉ der Hochspannungskaskadenschaltung.

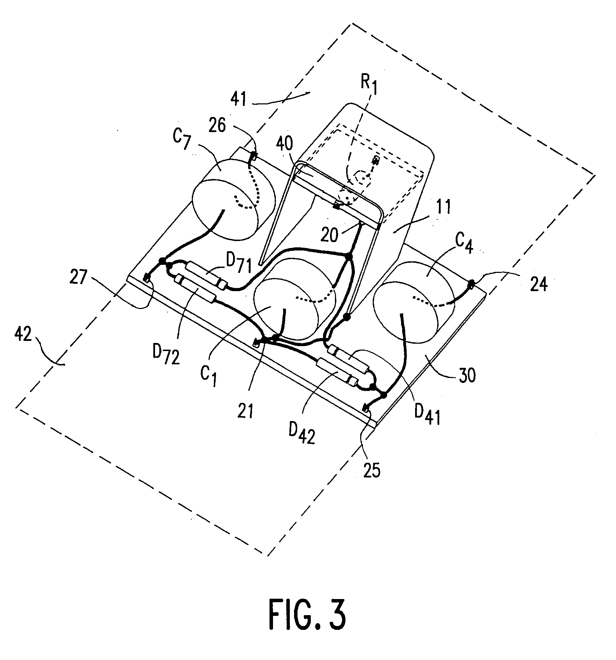

Der mechanische Aufbau der ersten Zweiweg-Verdopplerstufe des Hochspannungsgenerators gemäß Fig. 2 ist in Fig. 3 dargestellt. Auf einer Leiterplatte 30 sind in der Mitte der Glättungskondensator C₁ sowie jeweils an einer Außenseite die Schubkondensatoren C₄ und C₇ angeordnet. An den Anschlußpunkten 25 bzw. 27 sind die Dioden D₄₁ und D₄₂ bzw. D₇₁ und D₇₂ angeschlossen, wobei die Dioden D₄₁ und D₇₁ am Anschlußpunkt 20 und die Dioden D₄₂ und D₇₂ am Anschlußpunkt 21 zusammengeführt sind. In einem Abstand oberhalb der Leiterplatte 30 und zwischen den Schubkondensatoren C₄ und C₇ ist auf einer kleinen Leiterplatte 40 der zu dieser Zweiweg-Verdopplerstufe gehörige Meßwiderstand R₁ angeordnet. Die Leiterplatte 40 ist von einem dünnen metallischen Blech 11 umgeben, das auch zur Befestigung der Leitetplatte 40 dient. Das Blech 11 ist auf der Literplatte 30 befestigt, in Form eines auf dem Kopf stehenden U gebogen und mit dem Punkt 21 leitend verbunden, um den Meßwiderstand R₁ nach den Seiten von den Wechselspannung führenden Schubkondensatoren C₄ und C₇ sowie nach oben hin von dem Erdpotential abzuschirmen, das sich in einem praktischen Aufbau eines Röntgengenerators in geringem Abstand oberhalb der gezeigten Anordnung befindet, wo eine geerdete Abdeckplatte verläuft.

Wie durch die von gestrichelten Linien eingerahmten Flächen 41 und 42 in Fig. 3 angedeutet wird, ergibt sich der Aufbau der in Figur 2 gezeigten Schaltung durch Aneinanderreihung dreier in Fig. 3 gezeigter Aufbauten nebeneinander. Die Zweiweg-Verdopplerstufen können jeweils auf einer Leiterplatte angeordnet sein, die dann zusammgesteckt werden, oder auf einer einzigen Leiterplatte aufgebaut sein. Die Abmessungen in der Höhe sind bei einem derartigen Aufbau deutlich geringer als die Abmessungen in der Breite und der Länge. Aufgrund der Integration der Meßwiderstandsanordnung in den Aufbau der Hochspannungskaskadenschaltung hat dieser Aufbau gegenüber der bekannten Anordnung einen deutlich geringeren Platzbedarf. Auch dadurch, daß parallel zu den Meßwiderständen keine parallel geschalteten Hochspannungs-Kompensationskondensatoren erforderlich sind, ergibt sich eine Kosten- und Platzersparnis.

Für die Erfindung spielt der Aufbau der Hochspannungskaskadenschaltung keine Rolle. Die Erfindung könnte auch bei anderen Hochspannungsgeneratoren, wie beispielsweise einem Leistungsgenerator mit einem Transformator angewendet werden. Einer Gleichrichterstufe kann nicht nur wie gezeigt jeweils ein Meßwiderstand sondern auch mehrere Meßwiderstände zugeordnet sein, wobei die einer Gleichrichterstufe zugeordneten Meßwiderstände von einem gemeinsamen Schirm umgeben sind.

Anwendung findet die Erfindung überall da, wo eine aufgrund von Schaltvorgängen mit Wechselspannung überlagerte Gleichspannung gemessen werden soll, beispielsweise in Gleichspannungserzeugen in Röntgenröhren, in Röntgenbildverstärkern, Monitoren, TV-Bildschirmen, Vakuumröhrenversorgungen und Netzteilen.

## Patentansprüche

1. Hochspannungsgenerator zur Erzeugung einer Gleichspannung (U_{DC}) aus einer Wechselspannung (U₁, U₂, U₃) mit einer mehrere Gleichrichterstufen (31,32,33) aufweisenden Gleichrichterschaltung (9) und einer Meßwiderstandsanordnung (8) zur Bildung einer der Gleichspannung (U_{DC}) proportionalen Meßspannung (U_{M}), wobei die Meßwiderstandsanordnung (8) pro Gleichrichterstufe (31,32,33) mindestens einen zugehörigen Meßwiderstand (R₁, R₂, R₃) aufweist,
dadurch gekennzeichnet, daß die Meßwiderstände (R₁, R₂, R₃) räumlich in die zugehörigen Gleichrichterstufen (31,32,33) integriert sind, daß die Meßwiderstände (R₁, R₂, R₃) von einem leitfähigen, auf Gleichspannungspotential liegenden Schirm (11, 12, 13) umgeben sind zur Abschirmung der Meßwiderstandsanordnung (8) gegen Erdpotential und gegen Wechselspannung führende Teile (C₄...C₉, 1, 2, 3) des Hochspannungsgenerators und daß der Schirm (11 12, 13) auf dem Gleichspannungspotential der zugehörigen Gleichrichterstufe (31,32,33) liegt.

2. Hochspannungsgenerator nach Anspruch 1,
dadurch gekennzeichnet, daß die Meßwiderstände (R₁, R₂, R₃) in einem Abstand von der zugehörigen Gleichrichterstufe (31,32,33) angeordnet und von einem als Schirm wirkenden dünnen Metallblech (11, 12, 13) umgeben sind.

3. Hochspannungsgenerator nach einem der vorhergehenden Ansprüche,
dadurch gekennzeichnet, daß die Gleichrichterschaltung (9) eine aus Kondensatoren (C₁...C₉) und Dioden (D₄₁, D₄₂, D₅₁.....D₉₂) aufgebaute Hochspannungskaskadenschaltung ist.

4. Hochspannungsgenerator nach Anspruch 3,
dadurch gekennzeichnet, daß der Schirm (11, 12, 13) ein U-förmig gebogenes Blech ist, das den Meßwiderstand (R₁, R₂, R₃) zu den Seiten von den Wechselspannung führenden Kondensatoren (C₄...C₉) der Hochspannungskaskadenschaltung abschirmt.

5. Hochspannungsgenerator nach einem der vorhergehenden Ansprüche,
dadurch gekennzeichnet, daß die Gleichrichterschaltung (9) und die Meßwiderstandsanordnung (8) auf einer einzigen Leiterplatte angeordnet sind.

6. Röntgengenerator mit einem Hochspannungsgenerator nach einem der vorhergehenden Ansprüche.

7. Röntgenanlage mit einem Röntgengenerator nach Anspruch 6.

8. Verwendung des Hochspannungsgenerators nach einem der Ansprüche 1 bis 5 zur Ansteuerung einer Röhre, insbesondere einer Bildröhre oder einer Röntgenröhre.
